# EUROPÄISCHE PATENTSCHRIFT

(11) **EP 0 883 238 B1**
(45) Veröffentlichungstag und Bekanntmachung des Hinweises auf die Patenterteilung: **13.10.2004**
(21) Anmeldenummer: 98108562.4
(22) Anmeldetag: 12.05.1998
(51) Int. Cl.: H03D 7/16, H03J 5/24

(54) **Empfänger für unterschiedliche Frequenzbänder**
Receiver for different frequency bands
Récepteur pour différentes bandes de fréquence

(30) Priorität: 03.06.1997 DE 19723175
(43) Veröffentlichungstag der Anmeldung: 09.12.1998
(73) Patentinhaber: ROBERT BOSCH GMBH, 70442 Stuttgart (DE)
(72) Erfinder: Bolle, Michael, 30880 Laatzen (DE); Clawin, Detlef, 33141 Hildesheim (DE)

(56) Entgegenhaltungen:
- EP-A- 0 534 278
- DE-A- 3 929 824
- DE-A- 4 126 774
- DE-A- 4 335 616
- FR-A- 2 368 828

## Beschreibung

### Stand der Technik

Die Erfindung geht aus von einem Empfänger für unterschiedliche Frequenzbänder nach der Gattung des Hauptanspruchs.

Ein solcher Empfänger ist aus FR 2 368 828 bekannt.

Die Planungen zur Einführung des digitalen Rundfunks (DAB) sind abgeschlossen. Für den Betrieb der Rundfunksender sind zwei Frequenzbänder festgelegt worden. Das Band III überdeckt Frequenzen von 170 bis 240 MHz und das L-Band einen Bereich von 1452 bis 1492 MHz. Die für diese beiden Frequenzbänder vorgesehenen Empfänger besitzen einen Diplexer, der die beiden Frequenzbänder trennt. Der Verarbeitungszweig des Bandes III arbeitet wie ein Fernsehempfänger. Nach einer Vorselektion durch abstimmbare Filter erfolgt eine Umsetzung auf eine Zwischenfrequenz von etwa 38 MHz. Bei dieser Frequenz übernimmt ein weiteres Filter die Selektion des mit 1,536 MHz-breiten Empfangskanals und führt es einem digitalen Signalprozessor zur weiteren Verarbeitung zu. Die Verarbeitung des L-Bandes wird üblicherweise durch eine Blockumsetzung mit einer festen Zwischenfrequenz auf das Band III realisiert. Bei einem solchen Empfängerkonzept, das mit niedrigliegender Zwischenfrequenz arbeitet, ist eine Vorselektion der Frequenz zur Unterdrückung von Spiegelfrequenzen notwendig. Da das Band III relativ breit im Vergleich zur Zwischenfrequenz ist, müssen die abstimmbaren Filter mit der Eingangsfrequenz mitgeführt werden. Hierzu ist ein aufwendiger Abgleich der Filter notwendig.

Ein bekanntes weiteres Konzept für die Realisierung von Empfängern vermeidet abstimmbare Filter mit einem Doppelsuper-Verfahren. Hierbei wird zunächst die Eingangsfrequenz auf eine hochliegende Zwischenfrequenz umgesetzt. Dies hat zur Folge, daß die Spiegelfrequenz sehr hoch liegt und mit einem einfachen, festen Filter unterdrückt werden kann. Nach einer Vorselektion wird die erste Zwischenfrequenz auf eine niedrigliegende zweite Zwischenfrequenz umgesetzt, die mit herkömmlichen Methoden weiterverarbeitet wird. Das Doppelsuper-Verfahren stellt erhöhte Anforderungen an verschiedene Systembausteine. Die Anforderung an die Oszillatoren bezüglich des reziproken Mischens bleiben zwar absolut gesehen gleich, jedoch müssen die gewünschten Leistungen bei höherer Frequenz realisiert werden. Dazu kommt, daß für den digitalen Rundfunk ein Phasenrauschen von minus 60 dBc im Abstand von 250 Hz neben dem Träger vorgeschrieben ist. Technisch bereitet die Realisierung eines Oszillators besondere Probleme, wenn ein großer Abstimmbereich gefordert ist. Deshalb sind im allgemeinen mehrere umschaltbare Oszillatormodule für jedes Band mit einem Doppelsuper-Konzept notwendig.

### Vorteil der Erfindung

Der erfindungsgemäße Empfänger mit den kennzeichnenden Merkmalen des Hauptanspruchs hat demgegenüber den Vorteil, daß ein Oszillator mit einem kleinen Abstimmbereich ausreicht, um eine geeignete erste Zwischenfrequenz für beide Frequenzbänder zu erreichen. Dabei werden die Vorteile des Doppelsuper-Konzeptes weiter genutzt und es sind keine abstimmbaren Filter notwendig. Dies wird möglich, indem die notwendigen Mischer-Frequenzen durch unterschiedliche Frequenzteiler aus einer gemeinsamen höher liegenden Oszillatorfrequenz abgeleitet werden.

Durch die in den Unteransprüchen aufgeführten Maßnahmen ist eine vorteilhafte Weiterbildung und Verbesserung des im Hauptanspruch angegebenen Empfängers möglich.
Es ist zusätzlich vorteilhaft, den gemeinsamen Oszillator über Frequenzteiler mit den Mischer der beiden Verarbeitungszweige zu verbinden und so zusätzlich das Phasenrauschen des Oszillators zu unterdrücken.
Weiterhin ist es von Vorteil, wenn die Frequenzen L-Band im Verhältnis 1:2 geteilt werden während die Frequenz für die Verarbeitung des Bandes III unverändert weitergegeben wird. Dadurch erhält man eine Zwischenfrequenz von 920 MHz, die nicht von anderen Funkdiensten mit starken Leistungen belegt sind. Weiterhin ist es eine vorteilhafte Ausbildung, die Oszillatorfrequenz bei 3 GHz, die Oszillatorfrequenz bei 3 GHz festzulegen und auf diese Weise eine Zwischenfrequenz von 880 MHz zu erhalten. Die Realisierung eines Oszillators, bzw. der notwendigen 1:3 und 1:5 Teiler sind in schneller Logik ohne Schwierigkeit zu realisieren. Es ist zudem technologisch möglich, den Oszillator aus einem Bauteil mit integrierten Spulen herzustellen.

### Zeichnung

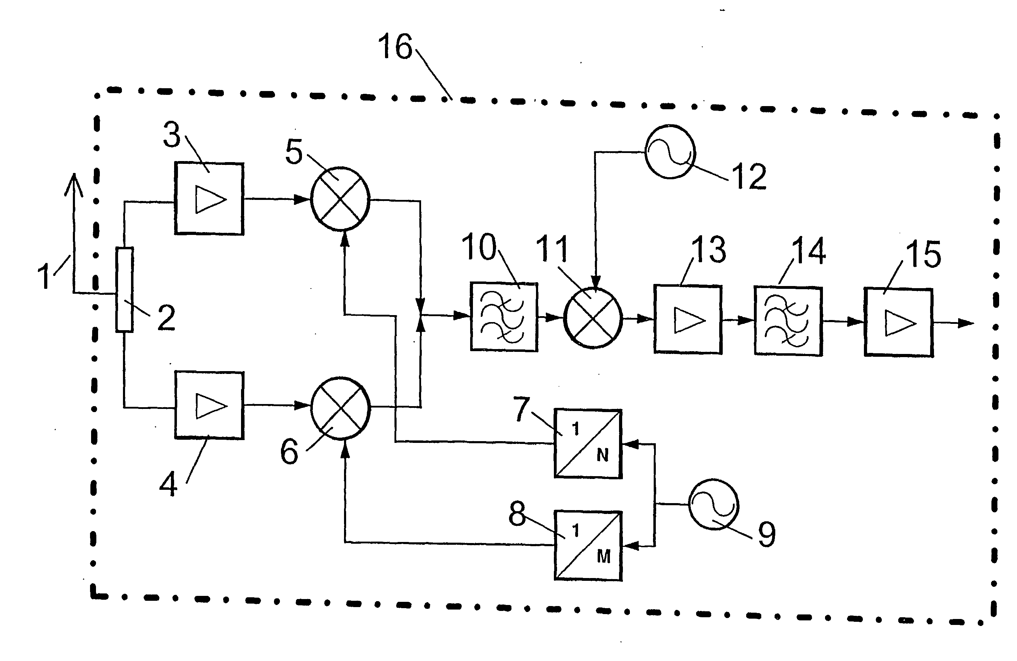

Ein Ausführungsbeispiel der Erfindung ist in der Zeichnung dargestellt und in der nachfolgenden Beschreibung näher erläutert. Es zeigt Figur 1 einen Empfänger mit erfindungsgemäßer Eingangsschaltung.

### Beschreibung des Ausführungsbeispiels

Ausgehend von der Antenne 1 des Empfängers 16 wird das Signal in einem Diplexer 2 in zwei Verarbeitungszweige getrennt. Der Diplexer 2 steht mit einem Vorverstärker des L-Bandes 3 und einem Vorverstärker des Bandes III 4 in Verbindung. Die Vorverstärker sind jeweils mit Mischern 5, 6 verbunden, die wiederum über Frequenzteiler 7 und 8 mit einem Oszillator 9 in Verbindung stehen. Die Ausgänge der Mischer 5 und 6 liegen am Eingang eines ersten Zwischenfrequenzfilters 10 an. Ein Zwischenfrequenzmischer 11 ist mit dem Ausgang des ersten Zwischenfrequenzfilters 10 und dem Ausgang des zweiten Oszillators 12 verbunden. Der Ausgang des Zwischenfrequenzmischers 11 liegt über einen Verstärker 13 an einem zweiten Zwischenfrequenzfilter 14 und an einem weiteren Verstärker 15 an. Das vorverstärkte Signal steht der weiteren Verarbeitung zur Verfügung.

Ein beliebiges Multiträgersignal des digitalen Rundfunks wird zunächst über die Antenne 1 empfangen. Das Signal wird zunächst einen Diplexer 2 zugeführt, der es in die beiden getrennten Verarbeitungszweige für das L-Band und das Band III trennt. Der Diplexer enthält zwei feste Bandpaßfilter, die potentielle Störer außerhalb des Bandes III und des L-Bandes unterdrücken. Mit jeweils für Band III und L-Band optimierte rauscharme Vorverstärkern 3 und 4 wird das Signal verstärkt und den Mischern 5 und 6 zugeführt. Die erste zu erreichende Zwischenfrequenz liegt zwischen der Frequenz der beiden Bänder, d.h. für das L-Band wird auf die erste Zwischenfrequenz heruntergemischt und das Band III auf die erste Zwischenfrequenz heraufgemischt. Das Mischen erfolgt in den Mischern mit Hilfe einer Frequenz, die von einem Oszillator 9 geliefert wird. Dem Oszillator 9 sind Frequenzteiler 7 und 8 vorgeschaltet, die die feste Frequenz des Oszillators geeignet teilen. Nachdem die erste Zwischenfrequenz hergestellt ist erfolgt die weitere Verarbeitung nach dem Doppelsuper-Konzept. Im ersten Zwischenfrequenzfilter 10 erfolgt eine Vorselektion. Über den Zwischenfrequenzmischer 11 wird das Signal auf eine zweite Zwischenfrequenz umgesetzt.

Das Signal mit der zweiten Zwischenfrequenz wird im Verstärker 13 verstärkt und einer Kanalselektion in einem zweiten Zwischenfreqenzfilter 14 unterworfen. Wichtig für die Erzeugung der ersten Zwischenfreqeuenz ist es, daß die notwendige Mischerfrequenz für die Mischer 5, 6 aus einer gemeinsamen Oszillatorfrequenz abgeleitet werden. Um eine geeignete gemeinsame Zwischenfrequenz für beide Bänder auswählen zu können, wird der Oszillator bei einer höheren Frequenz betrieben und durch unterschiedliche Frequenzteiler die Mischerfrequenzen für das L-Band und das Band III abgeleitet. Dabei wird zusätzlich das Phasenrauschen des Oszillators entsprechend dem eingestellten Verteilungsverhältnis verbessert. Es sind besonders die Teilungsverhältnisse 1:3. 1:5 bei einer Oszillatorfrequenz von etwa 3 GHz interessant, da die damit erzeugte Zwischenfrequenz von 880 MHz nicht von anderem Funkdienst mit starken Leistungen belegt sind. Ein weiteres Teilungsverhältnis von 1:2 und 1:1, d.h. in einem Zweig wird auf einen Frequenzteilung verzichtet, bei einer Oszillatorfrequenz von 1,1 GHz erzeugt eine Zwischenfrequenz von 920 MHz. Teiler sind auf einfache Weise in schneller Logik (ECL, CML) zu realisieren. Für den Empfänger werden beispielsweise Mischer 5 und 6 eingesetzt die optimal an die beiden Frequenzbänder angepaßt sind. Die Mischer 5 und 5 können aus einem Mischerkern und einem nachgeschalteten Verstärker bestehen.
Es ist durchaus auch möglich, einen gemeinsamen Mischer für die beiden Bänder zu verwenden, oder auch zusätzliche Filter zwischen Mischer und Filter anzuordnen.

Bezüglich einer festen Oszillatorfrequenz von 3 GHz ist ein Aufbau des gesamten Empfängerbauteils mit vollständiger Integration möglich. Dabei wird auch der Oszillator 9 mit in die Schaltung integriert. Dabei ist die Verwendung von integrierten Spulen möglich, deren Güte mit der Frequenz steigt.

Dadurch ergeben sich bei etwa 3 GHz günstige technische Lösungen für ein vollständig integriertes Bauteil.

## Patentansprüche

1. Empfänger (16) für unterschiedliche, in einem Multiträgerübertragungsverfahren ausgesendete Frequenzbänder, wobei die Signale der Frequenzbänder in einem Diplexer (2) getrennt und in getrennten Verarbeitungszweigen auf eine erste gemeinsame Zwischenfrequenz gemischt und in einem Doppelsuper-Verfahren weiterverarbeitet werden, **dadurch gekennzeichnet, daß** in jedem Verarbeitungszweig ein Vorverstärker (3, 4) und ein Mischer (5, 6) mit unterschiedlichen Mischverhältnissen zum Erreichen einer ersten gemeinsamen, zwischen den Frequenzbändern liegenden Zwischenfrequenz eingebaut ist.

2. Empfänger nach Anspruch 1, **dadurch gekennzeichnet, daß** die Mischer (5, 6) über mindestens einen Frequenzteiler (7, 8) mit einem gemeinsamen Oszillator (9) verbunden sind.

3. Empfänger nach Anspruch 1 oder 2, **dadurch gekennzeichnet, daß** der Frequenzteiler (7) des L-Bandes die Frequenz des gemeinsamen Oszillators (9) im Verhältnis 1:2 teilt und der Frequenzteiler (8) des III-Bandes die Oszillatorfrequenz 1:1 weitergibt.

4. Empfänger nach Anspruch 1 bis 3, **dadurch gekennzeichnet, daß** die erste Zwischenfrequenz bei etwa 919 MHz liegt.

5. Empfänger nach Anspruch 1 bis 4, **dadurch gekennzeichnet, daß** der gemeinsame Oszillator (9) bei etwa 3 GHz arbeitet und der Frequenzteiler des L-Bandes die Frequenz mit 5, der Frequenzteiler des III-Bandes die Frequenz mit 3 teilt.

6. Empfänger nach Anspruch 1 bis 5, **dadurch gekennzeichnet, daß** der gemeinsame Oszillator (9) in integrierter Technik mit integrierten Spulen im Empfänger aufgebaut ist.

## Claims

1. Receiver (16) for different frequency bands which are transmitted using a multicarrier transmission method, with the signals in the frequency bands being separated in a diplexer (2) and being mixed in separate processing paths onto a first common intermediate frequency and being processed further using a double-super method, **characterized in that** each processing path contains a preamplifier (3, 4) and a mixer (5, 6) with different mixing relationships in order to achieve a first common intermediate frequency, which is located between the frequency bands.

2. Receiver according to Claim 1, **characterized in that** the mixers (5, 6) are connected to a common oscillator (9) via at least one frequency divider (7, 8).

3. Receiver according to Claim 1 or 2, **characterized in that** the L band frequency divider (7) divides the frequency of the common oscillator (9) in the ratio 1:2, and the III band frequency divider (8) passes on the oscillator frequency 1:1.

4. Receiver according to Claims 1 to 3, **characterized in that** the first intermediate frequency is about 919 MHz.

5. Receiver according to Claims 1 to 4, **characterized in that** the common oscillator (9) operates at about 3 GHz, and the L band frequency divider divides the frequency by 5, with the III band frequency divider dividing the frequency by 3.

6. Receiver according to Claims 1 to 5, **characterized in that** the common oscillator (9) is constructed using integrated technology, with integrated coils in the receiver.

## Revendications

1. Récepteur (16) pour différentes bandes de fréquences envoyées par un procédé de transmission à porteuses multiples, les signaux des bandes de fréquences étant séparés dans un diplexeur (2), mélangés dans des branches de traitement séparées pour obtenir une première fréquence intermédiaire commune puis traités ultérieurement dans un procédé superhétérodyne à double conversion,
**caractérisé en ce que**
dans chaque branche de traitement sont installés un préamplificateur (3, 4) et un mélangeur (5, 6) avec des rapports de mélange différents pour obtenir une première fréquence commune située entre les bandes de fréquences.

2. Récepteur selon la revendication 1,
**caractérisé en ce que**
les mélangeurs (5, 6) sont reliés à un oscillateur (9) commun par l'intermédiaire d'au moins un diviseur de fréquences (7, 8).

3. Récepteur selon la revendication 1 ou 2,
**caractérisé en ce que**
le diviseur de fréquences (7) de la bande L divise la fréquence de l'oscillateur (9) commun dans un rapport de 1 : 2, et le diviseur de fréquences (8) de la bande III transmet la fréquence d'oscillateur à 1 : 1.

4. Récepteur selon la revendication 1 à 3,
**caractérisé en ce que**
la première fréquence intermédiaire se situe à 919 MHz environ.

5. Récepteur selon la revendication 1 à 4,
**caractérisé en ce que**
l'oscillateur commun (9) travaille à 3 GHz environ et le diviseur de fréquences de la bande L divise la fréquence par 5 alors que le diviseur de fréquences de la bande III divise la fréquence par 3.

6. Récepteur selon la revendication 1 à 5,
**caractérisé en ce que**
l'oscillateur (9) commun est construit selon la technique intégrée avec des bobines intégrées dans le récepteur.
